# DEMANDE DE BREVET EUROPEEN

(11) **EP 1 298 732 A1**
(43) Date de publication de la demande: **02.04.2003**
(21) Numéro de dépôt: 02354144.4
(22) Date de dépôt: 25.09.2002
(51) Int. Cl.: H01L 29/06, H01L 21/762

(54) **Périphérie haute tension**

(30) Priorité: 26.09.2001 FR 0112383
(71) Demandeur: STMicroelectronics S.A., 92120 Montrouge (FR)
(72) Inventeur: Gardes, Pascal, 37100 Tours (FR)
(74) Mandataire: de Beaumont, Michel

(57) **Abrégé**

L'invention concerne un procédé de formation d'un composant dans une partie d'un substrat semiconducteur (1) sur isolant (3) délimitée par un mur latéral (21) séparé par une couche d'isolement (10) d'une région périphérique (8) interne à ladite partie et fortement dopée d'un même premier type de conductivité que ledit substrat. Un plateau conducteur (22) est formé en même temps que ledit mur, sur une couche de protection (6) de la surface du substrat, en contact électrique avec la région périphérique, ledit plateau s'étendant au-dessus de ladite région périphérique vers l'intérieur de ladite partie par rapport au mur au-delà de l'aplomb de la limite entre la région périphérique et le substrat.

## Description

La présente invention concerne, de façon générale, la réalisation de composants discrets dans des tranches de silicium. Plus particulièrement, la présente invention concerne la périphérie de composants haute tension dans des tranches de silicium sur isolant.

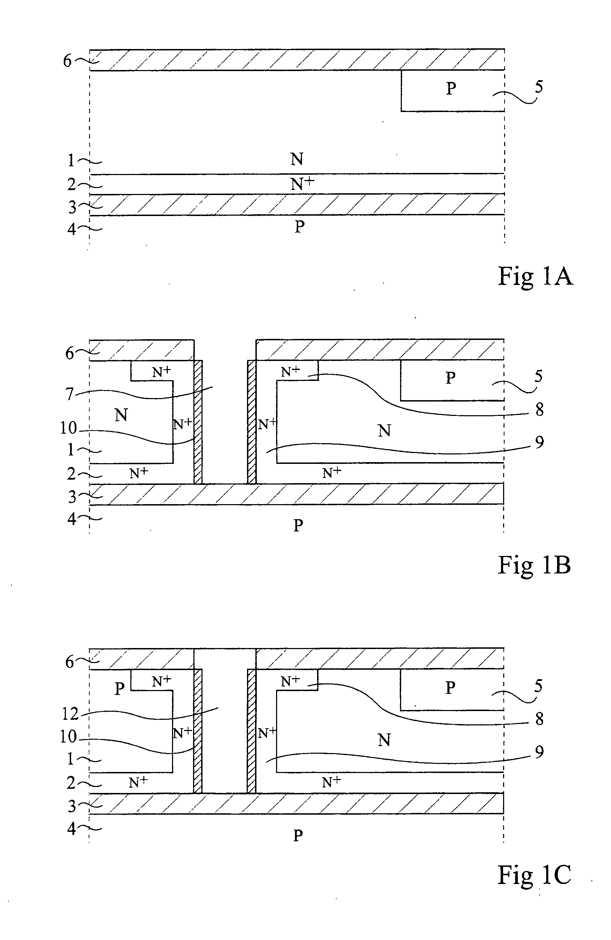

Les figures 1A à 1D illustrent, en vue en coupe schématique et partielle, différentes étapes de formation d'un composant discret haute tension dans un substrat semiconducteur sur isolant (SOI).

Comme l'illustre la figure 1A, on part d'un substrat 1 de silicium monocristallin d'un premier type de conductivité, par exemple N. Le substrat 1 comporte une couche enterrée 2 fortement dopée de même type N qui repose sur une couche isolante 3, typiquement d'oxyde de silicium, portée par un substrat inférieur 4 de silicium monocristallin du second type de conductivité, par exemple P. Cet assemblage est typiquement réalisé par collage de deux plaquettes de silicium séparées par un isolant et arasement de l'une des plaquettes. Comme cela est illustré à droite de la figure, on a par exemple formé dans le substrat 1 un ou plusieurs éléments du composant à réaliser tels qu'un caisson 5 faiblement dopé de type P. L'implantation du caisson 5 est suivie de la formation, sur toute la surface découverte du substrat 1, d'une couche de protection 6, généralement d'oxyde de silicium.

Comme cela est illustré en figure 1B, la périphérie du composant discret est définie par une tranchée 7 rejoignant la couche isolante 3. La tranchée 7 est destinée à séparer, c'est-à-dire isoler, deux composants voisins. À titre d'exemple, on considère que la tranchée 7 sépare le composant considéré d'une portion du substrat 1 inutilisée (à gauche de la figure) séparée d'un autre composant (non représenté) par une autre tranchée (non représentée). L'ouverture de la tranchée 7 est suivie d'un dopage de ses flancs. On forme ainsi, à la surface du substrat 1, à la périphérie du composant, une région 8 fortement dopée de type N en contact avec la couche enterrée 2 par l'intermédiaire d'une région verticale 9 le long de la paroi de la tranchée 7. On forme ensuite sur les parois de la tranchée 7 une couche d'isolement 10, typiquement d'oxyde de silicium thermique.

Ensuite, comme l'illustre la figure 1C, on dépose un matériau de façon à remplir complètement la tranchée 7. Le matériau est de préférence un matériau isolant ou amorphe, généralement du silicium polycristallin non dopé. Le matériau est ensuite éliminé en dehors de la tranchée par un polissage mécano-chimique (CMP). On a ainsi formé autour de la partie du substrat 1 dans laquelle est formé le composant un mur périphérique 12 séparé des régions périphérique 8 et verticale 9 et de la couche enterrée 2 par la couche d'isolement 10.

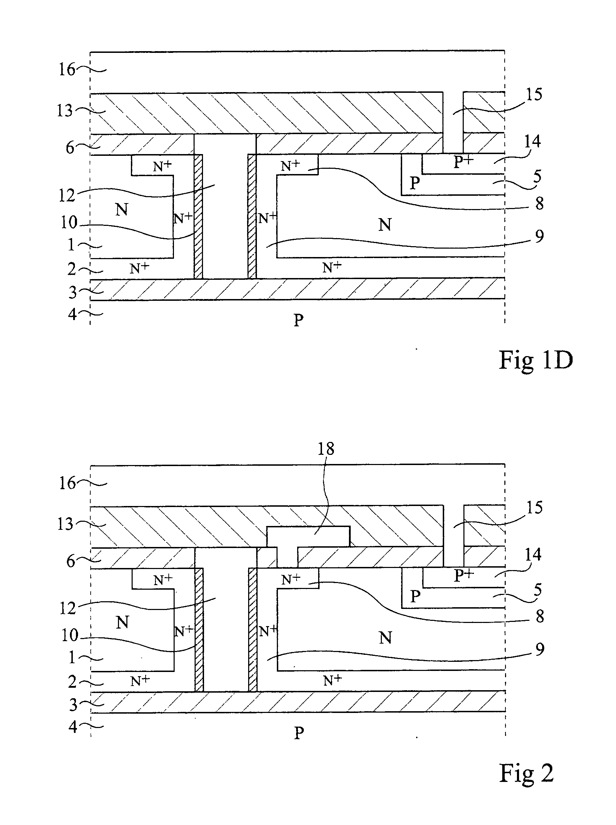

Comme l'illustre la figure 1D, la structure est ensuite revêtue d'une couche 13 d'un diélectrique. Le procédé se poursuit par la formation dans et/ou autour du caisson 5 de régions spécifiquement dopées, puis de contacts entre des pistes métalliques formées sur le diélectrique 13 et de telles régions spécifiques et/ou le caisson 5 et/ou le substrat 1 et/ou la région périphérique 8 avant d'effectuer la passivation de l'ensemble. Le composant ainsi formé peut être tout type de composant haute tension tel qu'un thyristor, un transistor bipolaire de type NPN ou PNP, ou encore une diode. À titre d'exemple non limitatif, la figure 1D illustre une région 14 fortement dopée de type P réalisée à la surface du caisson 5 et mise en contact par l'intermédiaire d'un via 15 avec une piste métallique superposée 16.

Un inconvénient de ce type de structure réside dans les problèmes de tenue en tension du composant. En effet, lors du fonctionnement du composant, on peut se trouver dans une situation dans laquelle l'ensemble du substrat 1, de la couche enterrée 2, du contact vertical 9 et de la région périphérique 8 doivent être maintenus à un niveau de potentiel haut alors que la métallisation 16 superposée est à un niveau de polarisation bas. On souhaite que la différence de potentiel entre les niveaux haut et bas puisse être élevée, par exemple de l'ordre de 600 volts. Pour ce faire, le composant est conçu avec un substrat 1 d'une épaisseur théoriquement appropriée, par exemple de l'ordre de 60 µm. En outre, il est connu que, pour atteindre ces niveaux de tensions élevés, il est souhaitable d'augmenter l'épaisseur d'isolant 6-13 entre la piste métallique 16 et le substrat 1 et/ou de sélectionner des isolants à faible permittivité diélectrique.

Toutefois, une telle surépaisseur est incompatible avec les procédés de fabrication usuels et pose de nombreux problèmes, notamment de contraintes mécaniques sur le substrat 1 sous-jacent, de formation des ouvertures nécessaires au dopage des régions spécifiques 14, ou de formation des vias 15. Les matériaux à faible permittivité, tels que le polyimide, posent également des problèmes en fabrication et imposent des précautions d'emploi, notamment de gravure, spécifiques.

Pour pallier ces inconvénients et pouvoir utiliser un isolant standard d'une épaisseur standard, on a proposé, comme l'illustre la figure 2, de former une plaque de champ métallique 18 en contact avec la région périphérique 8 et s'étendant au-delà de la frontière entre cette région et le substrat 1. Toutefois, la formation d'une telle plaque impose à partir de la formation du mur 12 décrite en relation avec la figure 1C, l'ouverture de la couche 6 et la mise en oeuvre d'étapes spécifiques de dépôt et de gravure d'une couche métallique selon le motif de la plaque 18. Pour permettre la gravure ultérieure de la couche métallique sans endommager le mur 12, son dépôt est précédé du dépôt d'une couche d'arrêt de gravure non représentée. Un tel recours à un niveau métallique supplémentaire complique donc le procédé de fabrication.

La présente invention vise à proposer des composants discrets haute tension qui pallient les inconvénients précédents.

La présente invention vise plus particulièrement à proposer une structure de composant de type SOI à plaque de champ qui soit simple à fabriquer.

Pour atteindre ces objets, la présente invention prévoit un procédé de formation d'un composant dans une partie d'un substrat semiconducteur sur isolant délimitée par un mur latéral séparé par une couche d'isolement d'une région périphérique interne à ladite partie et fortement dopée d'un même premier type de conductivité que ledit substrat. Un plateau conducteur est formé en même temps que ledit mur, sur une couche de protection de la surface du substrat, en contact électrique avec la région périphérique, ledit plateau s'étendant au-dessus de ladite région périphérique vers l'intérieur de ladite partie par rapport au mur au-delà de l'aplomb de la limite entre la région périphérique et le substrat.

Selon un mode de réalisation de la présente invention, la formation du mur et du plateau en contact avec la région périphérique est effectuée de façon à former simultanément un plateau supplémentaire prolongeant le mur, indépendant du plateau en contact avec la région périphérique et dont la surface supérieure est coplanaire à celle du plateau en contact avec la région périphérique.

Selon un mode de réalisation de la présente invention, la formation du plateau en même temps que celle du mur comporte les étapes consistant à former une tranchée périphérique à la partie du substrat correspondant au composant de façon à découvrir partiellement l'isolant ; former une couche d'isolement sur les parois de la tranchée ; ouvrir la couche de protection de façon à découvrir partiellement la région périphérique ; déposer un matériau conducteur simultanément dans la tranchée et autour de celle-ci sur la couche de protection de façon que sa surface soit sensiblement plane ; et graver le matériau conducteur de façon à former le plateau en contact avec la région périphérique et, dans la tranchée, le mur latéral.

Selon un mode de réalisation de la présente invention, l'étape de gravure du matériau conducteur est effectuée de façon à former, en même temps que le plateau en contact avec la région périphérique, le plateau supplémentaire.

Selon un mode de réalisation de la présente invention, le matériau conducteur est un semiconducteur dopé du premier type de conductivité.

Selon un mode de réalisation de la présente invention, le substrat comporte une couche enterrée du premier type de conductivité reposant sur l'isolant, la région périphérique étant mise en contact avec la couche enterrée par une région verticale.

Selon un mode de réalisation de la présente invention, ce procédé comporte en outre, entre les étapes de formation de la tranchée et de la couche d'isolement, l'étape consistant à doper les flancs de la tranchée, d'où il résulte que la région périphérique et la région verticale sont formées simultanément.

La présente invention prévoit aussi un composant discret haute tension formé dans une partie d'un substrat semiconducteur sur isolant délimitée par un mur latéral séparé par une couche d'isolement d'une région périphérique interne à ladite partie et fortement dopée d'un même premier type de conductivité que ledit substrat. Ce composant comporte un plateau conducteur en contact électrique avec la région périphérique, le plateau reposant sur une couche de protection de la surface du substrat, et s'étendant au-dessus de ladite région périphérique vers l'intérieur de ladite partie par rapport au mur au-delà de l'aplomb de la limite entre la région périphérique et le substrat, ledit plateau étant constitué du même matériau conducteur que ledit mur latéral.

Selon un mode de réalisation de la présente invention, le composant comporte en outre un plateau supplémentaire prolongeant le mur latéral, le plateau supplémentaire étant constitué du même matériau conducteur que le mur et étant distinct du plateau en contact avec la région périphérique, les surfaces supérieures des deux plateaux étant coplanaires.

Selon un mode de réalisation de la présente invention, le matériau conducteur est un semiconducteur fortement dopé du premier type de conductivité.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A à 1D illustrent, en vue en coupe schématique et partielle, différentes étapes de formation d'un composant discret haute tension selon un procédé classique ;
la figure 2 illustre, en vue en coupe schématique et partielle, un état intermédiaire d'un composant discret réalisé selon un autre procédé classique ; et
les figures 3A à 3C illustrent, en vue en coupe schématique et partielle, différentes étapes de formation d'un composant discret selon la présente invention.

Par souci de clarté, de mêmes références désignent aux différentes figures de mêmes éléments. En outre, comme cela est habituel dans la représentation des composants semiconducteurs, les différentes figures ne sont pas à l'échelle.

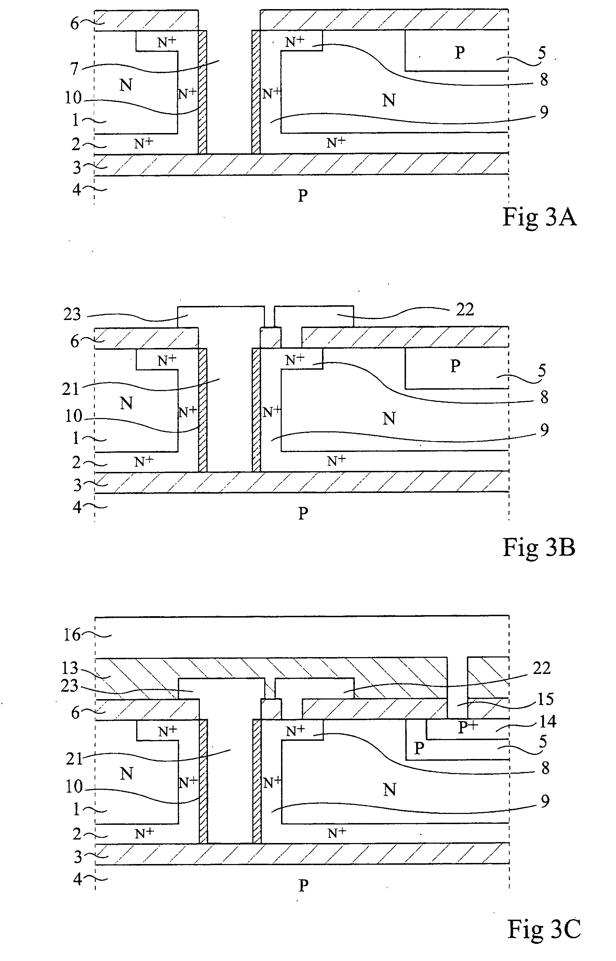

Comme l'illustre la figure 3A, la présente invention, prévoit un procédé de fabrication utilisant des étapes initiales identiques à celles décrites en relation avec les figures 1A et 1B.

Ensuite, comme l'illustre la figure 3B, le procédé selon la présente invention se poursuit par l'ouverture de la couche de protection 6, de façon à découvrir partiellement la région périphérique 8. On dépose ensuite un matériau conducteur, de préférence du silicium polycristallin fortement dopé de type N (le même type de conductivité que la région 8), qui remplit la tranchée d'isolement (7, figure 3A) et recouvre l'ensemble de la structure. On peut procéder à un polissage mécano-chimique ou autre, pour conférer au matériau une surface supérieure sensiblement plane. La partie du matériau remplissant la tranchée constitue un mur périphérique ou latéral 21 séparé des régions périphérique 8 et verticale 9 et de la couche enterrée 2 par la couche d'isolement 10. Une gravure est effectuée de façon à former deux plateaux distincts. Un premier plateau 22 est en contact avec la région périphérique 8 et s'étend vers le caisson 5, sans l'atteindre, au-delà de l'aplomb de la limite entre cette région 8 et le substrat 1 pour constituer une plaque de champ. Un second plateau 23 contacte le mur 21.

Comme l'illustre la figure 3C, la formation d'un composant discret selon l'invention s'achève par la formation dans et autour du caisson 5 de régions spécifiquement dopées 14, par le dépôt d'une couche d'un diélectrique 13 et par la formation de contacts 15. Le nombre, la nature et la disposition de telles régions 14 et contacts 15 varient en fonction du composant formé, par exemple, un thyristor, un transistor bipolaire de type PNP ou NPN ou une diode. Les contacts 15 permettent de connecter au moyen de pistes métalliques 16 le composant obtenu à d'autres composants ou à des sources d'alimentation.

La formation des plateaux 22 et 23 à partir d'un même dépôt de silicium polycristallin selon la présente invention permet de réaliser des plaques de champ lors de la même étape de fabrication que le remplissage des tranchées d'isolement et simplifie donc le procédé de fabrication.

Bien entendu, la présente invention est susceptible de diverses variantes et modifications qui apparaîtront à l'homme de l'art. En particulier, on a considéré dans l'exemple détaillé que chaque composant discret est séparé du composant discret voisin par la succession d'une première tranchée d'isolement, d'une zone non utilisée du substrat 1 et d'une autre tranchée d'isolement. Toutefois, il est également possible de séparer deux composants discrets par une seule tranchée d'isolement. Alors, l'extension du plateau 23 en contact avec le remplissage de la tranchée est limitée et un plateau est formé en contact avec la région périphérique du composant voisin. En outre, il est également possible, dans l'un ou l'autre cas, de ne former que le seul plateau 22 contactant la région périphérique 8. Toutefois, la formation simultanée du plateau supplémentaire 23 permet de stabiliser la répartition des équipotentielles à proximité de la région périphérique 8 sans compliquer le procédé.

De façon générale, les principes de l'invention ne sont pas limités aux exemples de la description précédente. Ainsi, l'homme du métier saura choisir les matériaux utilisés en fonction de la filière technologique considérée en respectant leur nature conductrice ou isolante telle que définie dans la description précédente. L'homme du métier saura par exemple adapter les matériaux à la nature du substrat semiconducteur dans lequel est formé le composant. En effet, les principes de l'invention ne sont pas limités à la réalisation d'un composant discret haute tension dans un substrat de silicium sur isolant, mais s'appliquent également à leur réalisation dans tout substrat semiconducteur sur isolant. De même, on a considéré que les parois de la tranchée d'isolement sont revêtues d'une couche (10) d'oxyde silicium thermique. Toutefois, elle pourrait être remplacée par une couche spécifiquement déposée, d'oxyde de silicium ou de tout autre isolant approprié. Par ailleurs, on a considéré dans la description précédente que le substrat, la région périphérique ou encore la couche enterrée sont de type de conductivité N. Ils pourraient également être du type de conductivité complémentaire P. Dans le cas où le matériau conducteur de remplissage de la tranchée d'isolement et de formation du ou des plateaux selon l'invention est un semiconducteur, on veillera à ce qu'il soit dopé du même type de conductivité que la région périphérique. Par ailleurs, dans le mode de réalisation décrit, on a formé dans le substrat une partie (caisson 5) des régions nécessaires à la réalisation du composant avant la formation de la périphérie et une autre partie (régions 14) après. Toutefois, toute région appropriée peut être formée à tout stade de formation de la périphérie selon l'invention.

## Revendications

1. Procédé de formation d'un composant dans une partie d'un substrat semiconducteur (1) sur isolant (3) délimitée par un mur latéral (21) séparé par une couche d'isolement (10) d'une région périphérique (8) interne à ladite partie et fortement dopée d'un même premier type de conductivité que ledit substrat, **caractérisé en ce qu'**un plateau conducteur (22) est formé en même temps que ledit mur, sur une couche de protection (6) de la surface du substrat, en contact électrique avec la région périphérique, ledit plateau s'étendant au-dessus de ladite région périphérique vers l'intérieur de ladite partie par rapport au mur au-delà de l'aplomb de la limite entre la région périphérique et le substrat.

2. Procédé selon la revendication 1, **caractérisé en ce que** la formation du mur (21) et du plateau (22) en contact avec la région périphérique (8) est effectuée de façon à former simultanément un plateau supplémentaire (23) prolongeant le mur, indépendant du plateau en contact avec la région périphérique et dont la surface supérieure est coplanaire à celle du plateau en contact avec la région périphérique.

3. Procédé selon la revendication 1 ou 2, **caractérisé en ce que** la formation du plateau (22) en même temps que celle du mur (21) comporte les étapes suivantes :
former une tranchée (7) périphérique à la partie du substrat (1) correspondant au composant de façon à découvrir partiellement l'isolant (3) ;
former une couche d'isolement (10) sur les parois de la tranchée ;
ouvrir la couche de protection (6) de façon à découvrir partiellement la région périphérique (8) ;
déposer un matériau conducteur simultanément dans la tranchée et autour de celle-ci sur la couche de protection de façon que sa surface soit sensiblement plane ; et
graver le matériau conducteur de façon à former le plateau en contact avec la région périphérique et, dans la tranchée, le mur latéral.

4. Procédé selon les revendications 2 et 3, **caractérisé en ce que** l'étape de gravure du matériau conducteur est effectuée de façon à former, en même temps que le plateau (22) en contact avec la région périphérique (8), le plateau supplémentaire (23).

5. Procédé selon la revendication 3 ou 4, **caractérisé en ce que** le matériau conducteur est un semiconducteur dopé du premier type de conductivité.

6. Procédé selon l'une quelconque des revendications 1 à 5, **caractérisé en ce que** le substrat (1) comporte une couche enterrée (2) du premier type de conductivité reposant sur l'isolant (3), la région périphérique (8) étant mise en contact avec la couche enterrée par une région verticale (9).

7. Procédé selon la revendication 6 et l'une quelconque des revendications 3 à 5, **caractérisé en ce qu'**il comporte en outre, entre les étapes de formation de la tranchée (7) et de la couche d'isolement (10), l'étape consistant à doper les flancs de la tranchée, d'où il résulte que la région périphérique (8) et la région verticale (9) sont formées simultanément.

8. Composant discret haute tension formé dans une partie d'un substrat semiconducteur (1) sur isolant (3) délimitée par un mur latéral (21) séparé par une couche d'isolement (10) d'une région périphérique (8) interne à ladite partie et fortement dopée d'un même premier type de conductivité que ledit substrat, **caractérisé en ce qu'**il comporte un plateau conducteur (22) en contact électrique avec la région périphérique, le plateau reposant sur une couche de protection (6) de la surface du substrat, et s'étendant au-dessus de ladite région périphérique vers l'intérieur de ladite partie par rapport au mur au-delà de l'aplomb de la limite entre la région périphérique et le substrat, ledit plateau étant constitué du même matériau conducteur que ledit mur latéral.

9. Composant selon la revendication 8, **caractérisé en ce qu'**il comporte en outre un plateau supplémentaire (23) prolongeant le mur latéral (21), le plateau supplémentaire étant constitué du même matériau conducteur que le mur et étant distinct du plateau (22) en contact avec la région périphérique (8), les surfaces supérieures des deux plateaux étant coplanaires.

10. Composant selon la revendication 8 ou 9, **caractérisé en ce que** le matériau conducteur est un semiconducteur fortement dopé du premier type de conductivité.
